Europäisches Patentamt

European Patent Office

Office européen des brevets

(19)

(11) Numéro de publication: **0 068 565**
**B1**

(12) **FASCICULE DE BREVET EUROPEEN**

(45) Date de publication du fascicule du brevet:
**08.08.84**

(51) Int. Cl.³: **C 09 D 11/02, H 05 K 3/12**

(21) Numéro de dépôt: **82200748.0**

(22) Date de dépôt: **17.06.82**

---

(54) **Mélange de départ pour une encre sérigraphiable contenant un verre au plomb à cuire en atmosphère non oxydante et encre sérigraphiable obtenue.**

---

(30) Priorité: **19.06.81 FR 8112123**

(43) Date de publication de la demande:
**05.01.83 Bulletin 83/1**

(45) Mention de la délivrance du brevet:
**08.08.84 Bulletin 84/32**

(84) Etats contractants désignés:
**BE DE FR GB NL**

(56) Documents cités:
**FR - A - 2 437 427**

(73) Titulaire: **Laboratoires d'Electronique et de Physique Appliquée L.E.P., 3, Avenue Descartes, F-94450 Limeil-Brévannes (FR)**

(84) Etats contractants désignés: **FR**

(73) Titulaire: **N.V. Philips' Gloeilampenfabrieken, Groenewoudseweg 1, NL-5621 BA Eindhoven (NL)**

(84) Etats contractants désignés: **BE DE GB NL**

(72) Inventeur: **Baudry, Hugues, Société Civile S.P.I.D. 209 rue de l'Université, F-75007 Paris (FR)**
Inventeur: **Monneraye, Marc, Société Civile S.P.I.D. 209 rue de l'Université, F-75007 Paris (FR)**
Inventeur: **Morhaim, Claude, Société Civile S.P.I.D. 209 rue de l'Université, F-75007 Paris (FR)**

(74) Mandataire: **Gendraud, Pierre et al, Société Civile S.P.I.D. 209, rue de l'Université, F-75007 Paris (FR)**

---

## Description

L'invention concerne un mélange de départ destiné à obtenir par addition d'un véhicule organique une encre sérigraphiable, à déposer en couche épaisse et à cuire sous atmosphère non oxydante et comprenant au moins, sous forme pulvérulente, une partie vitreuse dite passive et une partie dite active. L'invention concerne également une encre sérigraphiable obtenue par dispersion dans un véhicule organique du susdit mélange de départ, ainsi que les circuits hybrides rélisés au moyen de cette encre.

L'invention a trait au domaine de la microélectronique, plus spécifiquement à la réalisation de microcircuits hybrides, pour lesquels il convient de formuler toute une gamme d'encres sérigraphiables adaptées aux divers supports utilisés.

De telles encres sérigraphiables sont bien connues de l'art antérieur et l'on citera pour mémoire, la plus ancienne demande de brevet sur ce sujet déposée le 25 mars 1975 au nom de la Demanderesse et publiée sous le numéro 2 305 478, protégeant une encre sérigraphiable conductrice, à base de cuivre, à déposer sur un support d'alumine frittée et à cuire sous atmosphère non oxydante (i. e. dont la teneur en oxygène est inférieure à 10 ppm).

L'utilisation d'un tel support en alumine frittée autorise la formulation de toute une gamme d'encres compatibles, à cuire sous atmosphère non oxydante à des températures aussi élevées que 850° C.

L'apparition récente sur le marché de nouveaux supports tels que par exemple la tôle émaillée utilisée notamment sous sa forme »noire«, du type émail-masse, par la firme ALPHAMETALS conduit nécessairement les fabricants à formuler de nouvelles gammes d'encres compatibles, à cuire à des températures plus basses, de l'ordre de 550° C, afin de ne pas détériorer l'émail du support.

L'invention vise à obtenir une nouvelle gamme d'encres comprenant une partie vitreuse à bas point de fusion, à cuire sous atmosphère non oxydante.

Il est connu de l'art antérieur que les verres au plomb — sous la forme PbO — présentent un bas point de fusion. Mais, il est également connu de l'art antérieur que ces verres lorsqu'ils sont sérigraphiés ne supportent pas la cuisson sous atmosphère neutre — par exemple sous azote — et se décomposent très rapidement , de telle sorte qu'il semblait impossible de les utiliser dans de telles conditions.

Cette décomposition provient d'une réduction de l'oxyde de plomb, lors de la cuisson d'une couche sérigraphiée sous atmosphère neutre, à des températures supérieures à 450° C.

En outre, le véhicule organique s'élimine mal de la couche sérigraphiée, notamment dans le cas des couches isolantes moins poreuses, ce qui provoque la rétention de résidus polluants, qui détérioient les qualités intrinsèques desdites couches et contribuent à la décomposition du verre.

La solution retenue pour éviter la décomposition du verre consistait à en modifier la composition de telle sorte qu'il ne contienne pas d'oxydes réductibles aux températures de cuisson envisagées. Mais cette solution entraînait alors un choix des oxydes formateurs du verre (SiO$_2$, ZnO, B$_2$O$_3$, CaO . . .) qui conduisait à des températures de cuisson élevées de l'ordre de 900 ° C et donc à des supports (en alumine frittée) capables de résister à ces températures de cuisson.

Afin d'éliminer mieux le véhicule organique, la Demanderesse a imaginé d'introduire dans le mélange de départ, des oxydes réductibles à un degré de valence unique au cours de la cuisson et dispersés en faibles quantités dans le véhicule organique, tels les oxydes de praséodyme (Pr$_6$O$_{11}$, PrO$_2$), de cérium (CeO$_2$) ou de cobalt (Co$_3$O$_4$), alors que, réduits au degré de valence inférieur, ces oxydes passaient en phase vitreuse, sans nuire aux propriétés de la couche sérigraphiée. Cette amélioration est notamment décrite et protégée par la demande de brevet français N° 2 437 427 déposée le 8 Septembre 1978.

Le problème ayant été inversé, i. e. le choix d'un support en tôle émaillée préconisé par les utilisateurs, cette solution n'était plus valable, et il convenait de s'orienter vers d'autres axes de recherche.

L'invention propose donc une solution nouvelle à ce problème de décomposition des verres au plomb et d'élimination des résidus organiques, en introduisant dans le mélange de départ un oxydant qui se trouve réduit au cours de l'étape de cuisson, et qui libère une quantité d'oxygène suffisante pour éviter la réduction de l'oxyde de plomb contenu dans le verre et pour »brûler« les résidus charbonneux.

Selon la présente invention, le mélange de départ est remarquable en ce qu'il comprend également un (ou pluseirs) oxyde(s) de plomb, à un degré d'oxydation supérieur à 2, sous forme pulvérulente, en des proportions volumiques comprises entre 0 (non compris) et 20%.

De cette manière, le mélange de départ comporte un oxydant, réductible à partir d'une température de 410° C, et qui permet ainsi d'éviter la décomposition du verre, tout en abaissant le point de recuit supérieur (PRS) du verre, car une fois réduit en PbO, il augmente la teneur du verre en oxyde de plomb et donc abaisse sa température de ramollissement (i. e. à une température donnée, sa viscosité est plus faible).

Selon une réalisation préférentielle de l'invention, le mélange de départ est remarquable en ce que l'on choisit comme oxyde, le bioxyde de plomb PbO$_2$, en des proportions volumiques comprises entre 5 et 15%.

De cette manière, parmi tous les oxydes de plomb dont le degré d'oxydation est supérieur à deux, tels que Pb$_2$O$_3$, Pb$_3$O$_4$ . . ., PbO$_2$, on choisit préférentiellement ce dernier qui présente le double avantage de se réduire dans une gamme de température adéquate, comprise entre 410° et 625°C, et de libérer une relativement plus grande quantité d'oxygène.

Selon un mode de réalisation de l'invention, un mélange de départ destiné à obtenir une encre sérigraphiable isolante est remarquable en ce que la partie vitreuse dite passive est une fritte de verre au plomb, à bas point de fusion, obtenue par fusion et broyage des oxydes suivants, avec leurs proportions molaires respectives: PbO (40—60%), SiO$_2$ (25—45%), Al$_2$O$_3$ (5—15%) et B$_2$O$_3$ (0—10%), préférentiellement la partie vitreuse, dite passive, est une fritte du verre suivant: PbO (57%), SiO$_2$ (33%) et Al$_2$O$_3$ (10%).

De cette manière, le point de recuit supérieur (PRS) du verre est aussi peu élevé que 440°C, et donc ce verre est utilisable pour la formulation d'une encre sérigraphiable isolante, à déposer en couches épaisses sur un substrat de tôle émaillée.

La description qui va suivre permettra de mieux comprendre comment l'invention s'exécute et de mieux en apprécier sa portée.

Un mélange de départ, destiné à être dispersé dans un véhicule organique commun, tel qu'une solution d'une résine dans un solvant, présentant une viscosité et un comportement rhéologique adéquat, par exemple de l'éthyl cellulose dans du terpinéol, comprend généralement au moins deux parties, sous forme pulvérulente, une partie vitreuse dite passive dont la fonction essentielle est de lier au substrat l'ensemble de la couche sérigraphiée, et une partie dite active, dont la fonction essentielle est de nature électrique.

L'encre sérigraphiable constituée à partir de ce mélange de départ doit traverser, lors de l'impression, un écran à mailles ou tamis, dont les dimensions sont d'autant plus fines que l'on désire obtenir une meilleure définition du motif reproduit. Les écrans utilisés habituellement présentent un nombre d'ouvertures par pouce linéaire (Mesh), de 325, ce qui représent une ouverture calculée en micromètres de l'ordre de 50 μm. Une bonne règle est d'utiliser des particules dont la taille est au moins 5 fois plus petite. Les poudres utilisées ont donc une dimension maximum de l'ordre de 10 μm, une forme sensiblement sphérique ou tout au moins sphéroîdale, et sont parfaitement compactes (denses, à surface non poreuse). Elles sont obtenues par broyage aux boulets, pendant une dizaine d'heures.

Les matériaux formant la partie dite active sont choisis en fonction des propriétés électriques désirées. En vue de la fabrication d'une encre conductrice, ces matériaux peuvent être par exemple de l'or ou de l'argent, et dans ce cas, l'encre obtenue pourra être cuite à l'air; ces matériaux peuvent être également des alliages, par exemple Au Pd, Ag Pd, Au Pt, et bien sûr Au Pt Pd, ces alliagesse réalisant au cors de la cuisson, alors que le mélange de départ contient initialement les métaux considérés en poudre. Mais le coût de ces matériaux a rendu prohibitives ces encres conductrices à base de métaux précieux, et a donc conduit les fabricants à la recherche de matériaux maoins coûteux. Le cuivre répond à ce critère, mais il suppose une cuisson en atmosphère non oxydante (pression partielle d'oxygène comprise entre 5 et 10 ppm). Une encre sérigraphiable au cuivre a donc été mise au point par la Demanderesse, qui fait l'objet du brevet précité N° 2 305 478. Le verre utilisé dans le cadre de ce brevet est formé essentiellement à partir des oxydes suivants: SiO$_2$ (5—20%), B$_2$O$_3$ (15—40%), Al$_2$O$_3$ (0—5%), ZnO (25—40%), CaO + Mgo (5—30%), Li$_2$O (0—10%). Il ne contient donc pas d'oxyde de plomb (PbO), et présente un point de recuit supérieur relativement élevé de 575°C.

Dans un brevet antérieur déposé aux Etats-Unis d'Amérique et délivré sous le numéro 3 647 532, il est décrit également une encre sérigraphiable conductrice au cuivre, alors que le verre proposé contient de l'oxyde de plomb; ceci nécessite donc une cuisson sous atmosphère légèrement oxydante (la pression partielle d'oxygène était comprise entre $10^{-1}$ et $10^{-4}$ atm), afin d'éviter la décomposition du verre, et un contrôle permanent et précis de l'atmosphère gazeuse introduite dans le four de cuisson des motifs sérigraphiés, alors qu'après cuisson dans une telle atmosphère, le verre devient un mauvais agent de scellement.

L'invention vise à s'affranchir de ce contrôle rigoureux, alors que l'avènement de nouveaux supports, tels que la tôle émaillée, destinés à supplanter dans de nombreux domaines l'alumine frittée, entraîne nécessairement les fabricants d'encre à renouveler toute leur gamme d'encres sérigraphiables, de façon à permettre une cuisson à une température inférieure à 600°C.

Conformément à l'invention, le mélange de départ est remarquable en ce qu'il contient également un (ou plusieurs) oxyde(s) de plomb, à un deŕe d'oxydation supérieur à 2, sous forme pulvérulente, en des porportions volumiques comprises entre 0 (non compris) et 20%.

Un tel mélange contient alors en lui-même une substance — en l'occurence, le bioxyde de plomb — qui, lorsque la température est suffisamment élevée, se réduit et libère donc de l'oxygène, en quantité suffisante pour éviter la réduction du plomb et contribuer à l'élimination du véhicule qui, présent sous la forme de résidus, provoquerait une dégradation des propriétés électriques et de soudabilité de la couche sérigraphiée.

Ces substances oxydantes peuvent être d'une façon générale tous les oxydes de plomb, de degré d'oxydation supérieur à 2, tels que Pb$_2$O$_3$, Pb$_3$O$_4$ ... et PbO$_2$, mais de préférence ce dernier, qui présente l'avantage de se réduire à l'etat de PbO, dans une gamme de températures comprise sensiblement entre 410°C et 625°C, et de libérer une quantité plus importante d'oxygène. En outre, une fois réduit à l'état de PbO, il participe à la formation du verre, ou plutôt il passe dans la phase vitreuse, et augmente la teneur du verre, en plomb, et donc diminue son point de recuit supérieure (PRS).

### Exemple I

#### encre sérigraphiable isolante

Selon un premier exemple de rélisation en vue d'obtenir une encre sérigraphiable isolante, la Demanderesse a réalisé initialement une fritte de verre à partir des oxydes formateurs suivants:

| pourcentage molaire | | |
|---|---|---|
| | PbO | 57% |
| | $SiO_2$ | 33% |
| | $Al_2O_3$ | 10% |

par fusion à une température voisine de 1200°C puis broyage pendant 64 heures, dans un broyeur à boulets jusqu'à ce que les grains atteignent une dimension maximum de l'ordre de 10 μm.

Les proportions molaires des oxydes peuvent varier dans une assez large mesure, par exemple:

| | |
|---|---|
| PbO | (40—60%) |
| $SiO_2$ | (25—45%) |
| $Al_2O_3$ | (5—15%) |
| $B_2O_3$ | (0—10%) |

ce dernier oxyde pouvant être rajouté en vue par exemple d'abaisser la viscosité de ce verre.

En vue de réaliser un mélange de départ pour une encre sérigraphiable isolante, il convient alors d'ajouter à la fritte de verre une charge céramique, sous forme pulvérulente telle que par exemple la magnésie (MgO), l'oxyde de lanthane ($La_2O_3$) ou l'aluminate de lanthane ($LaAlO_3$). Ce dernier est plus particulièrement choisi du fait de son coefficient de dilatation linéaire $[\alpha = 95 \cdot 10^{-7} °C^{-1} (20—700°C)]$, adapté au support en tôle émaillée de valeur:

$$[\alpha' = 110 \cdot 10^{-7} °C^{-1} (20—700°C)].$$

L'aluminate de lanthane est préparé par mélange de poudre d'alumine ($Al_2O_3$) et d'oxyde de lanthane ($La_2O_3$), disponibles commercialement, dans un broyeur planétaire, et traitement thermique double, à 1200°C pendant quatre heures, puis 1600°C pendant quinze heures. Le produit final est broyé pendant quelques heures, en phase aqueuse, au broyeur planétaire, afin d'obtenir une granulométrie convenable.

La fritte de verre telle que précédemment décrite, et la charge céramique sont alors mélangées en ce qu'il est coutume d'appeler un »mélange de départ pour encre sérigraphiable« en l'espèce isolante, alors qu'il ne manque plus que le véhicule organique, pour obtenir l'encre sérigraphiable. Une bonne compacité de l'isolant est obtenue avec une concentration volumique en verre supérieure à celle de la charge céramique, dans le susdit mélange de départ, par exemple dans un rapport 3/1.

L'aluminate de lanthane apparaît parmi les diverses charges céramiques testées comme celle présentant la meilleure compatibilité avec le verre décrit (PbO = 57%, $Al_2O_3$ = 10%, $SiO_2$ = 33%), qui est d'ailleurs l'un des plus visqueux parmi la sélection proposée, puisque ne contenant pas d'oxyde de bore.

Mais, de tels mélanges de départ et encres sérigraphiables constituées à partir d'eux, s'ils peuvent être cuits à l'air, et donc compatibles avec des encres conductrices Ag-Pd (85—15), se décomposent et charbonnent par cuisson sous atmosphère neutre, et ne sont donc pas, en cet état, compatibles avec des encres conductrice cuivre.

Conformément à la présente invention, le mélange de départ est remarquable en ce qu'il contient en outre, un oxydant capable de se réduire à une température relativement basse, par exemple au voisinage de 400°C, de façon à permettre une cuisson sous atmosphère neutre (azote), à faible température (inférieure à 600°C). Selon les recherches menées par la Demanderesse, les oxydes de plomb, de degré supérieur à 2, tels que $PbO_2O_3$, $Pb_3O_4$ ..., $PbO_2$ conviennent à cet effet, et parmi eux, préférentiellement $PbO_2$, dont la température de décomposition se situe entre 410 et 625°C, alors que le produit de décomposition PbO peut passer en phase vitreuse, et ainsi augmenter la teneur du verre en plomb et donc abaisser sa température de remollissement.

L'efficacité de l'addition de tels oxydes de plomb a été démontrée en préparant des encres, à teneur croissante, en les sérigraphiant et les cuisant à une température de 600°C. Le passage progressif de la teinte noire (verre décomposé = plomb métallique) à la teinte orangée ($Pb_3O_4$) montre clairement l'avantage de cette addition. Des teneurs diverses comprises entre 0 (non compris) et 20% ont été testées pour les divers oxydes de plomb, qui ont permis de cerner la teneur de $PbO_2$, conduisant à des résultats convenables; la quantité de bioxyde de plomb $PbO_2$ nécessaire était voisine de 10%, en proportions volumiques, et très généralement comprises entre 5 et 15% pour donner des résultats satisfaisants.

L'oxyde de plomb, ainsi rajouté dans le mélange de départ est susceptible d'evoluer selon deux voiesdifférentes:

— passer en phase vitreuse, après réduction, et augmenter la teneur du verre en plomb, et donc abaisser sa température de ramollissement et améliorer entre autres la mouillabilité de la céramique par le verre;

— rester en phase céramique, si la dissolution par le verre est incomplète ou nulle.

L'expérience a montré que le meilleur rapport entre les divers constituants du mélange de départ était le suivant:

| | | |
|---|---|---|
| Verre ($PbO/SiO_2/Al_2O_3$) | 85% | |
| $LaAlO_3$ | 3% | en volume |
| $PbO_2$ | 12% | |

### Exemple II

#### encre sérigraphiable conductrice

Selon un deuxième exemple de rélisation, en vue de réaliser une encre sérigraphiable conductrice, la Demanderesse a réalisé initialement une fritte de verre, à partir des oxydes formateurs suivants:

| | | |
|---|---|---|
| PbO | 57% | |
| $SiO_2$ | 23% | en pourcentage molaire |
| $B_2O_3$ | 20% | |

les proportions molaires des oxydes peuvent varier dans une assez large mesure, par exemple:

| | |
|---|---|
| PbO | (40—60%) |
| $SiO_2$ | (15—30%) |
| $B_2O_3$ | (10—30%) |

En vue de réaliser un mélange de départ, pour une encre sérigraphiable conductrice, il convient alors d'ajouter à cette fritte de verre, du cuivre, sous forme pulvérulente, dans des proportions volumiques telles que la partie passive (fritte de verre) soit inférieure à 15%, par exemple une proportion entre les parties actives/passives de l'ordre de 95%/5%. En outre, le véhicule organique — par exemple de l'ethyl cellulose dans du terpineol — est rajouté pour obtenir une encre sérigraphiable, avec une proportion volumique supérieure à 55%, par exemple une proportion entre le mélange de départ et le véhicule de 40%/60%.

Conformément à la présente invention, des oxydes de plomb, de degré supérieur à 2, tels que $Pb_2O_3$, $Pb_3O_4$ ... $PbO_2$ peuvent être rajoutés, mais en des proportions moindres que dans le cas des encres isolantes, car il risque d'oxyder le cuivre, par exemple de l'ordre de quelques pourcents.

Il faut remarquer ici, que l'addition d'un oxydant aux encres conductrices au cuivre est superfétatoire, car la porosité de la couche sérigraphiée permet la combustion des résidus charbonneux, avec les quelques traces d'oxygène présente dans l'atmosphère du four. Alors que dans le cas des encres isolantes, la couche est fermée, par suite d'une grande proportion de verre, et il y aura formation de cloques, par dégagement des gaz résiduels tardivement, par exemple à une température comprise entre le PRS et le palier.

La compatibilité des encres sérigraphiables obtenue sà partir de ces mélanges de départ, est excellente.

En outre, la cuisson pouvant s'effectuer à des températures de 550°C environ, pendant environ dix minutes, il est alors possible d'utiliser une telle gamme d'encre sérigraphiable, pour dépôt au travers d'un écran, sur un support en tôle émaillée et cuisson, en atmosphère non oxydante à basse température, en vue d'obtenir un réseau de couches sérigraphiées, du type simple ou multicouches, remarquables pour leurs propriétés conductrice (encre au cuivre) ou isolantes (encre à l'aluminate de lanthane), pour constituer par exemple des circuits hybrides.

En effet, la technique des couches épaisses déposées par sérigraphie convient particulièrement bien, pour obtenir le dépôt des réseaux conducteurs et isolants, dans des circuits hybrides. Le procédé de dépôt consiste à appliquer ces encres par impression au travers d'un écran de sérigraphie, selon le motif désiré, puis à les sécher et à les cuire pour les faire adhérer au support.

Une séquence typique, pour la réalisation d'un circuit hybride consiste alors en les étapes suivantes:

a) choisir un support libre, de dimensions adaptées aux besoins du circuit, ce qui est très aisé en technologie tôle émaillée (découpe et émaillage »à la demande«);

b) sérigraphier un premier réseau de conducteurs;

c) cuire sous atmosphère d'azote à 550°C, pendant environ 10 minutes;

d) sérigraphier en double couche les zones isolantes aux localisations prévues pour le croisement des conducteurs;

e) cuire sous atmosphère d'azote pendant environ 10 minutes;

f) sérigraphier et cuire le deuxième réseau de conducteurs croisant la premier sur les zones sérigraphiées en d);

g) compléter le support avec des composants discrets, tels que des transistors, diodes, réstances ...

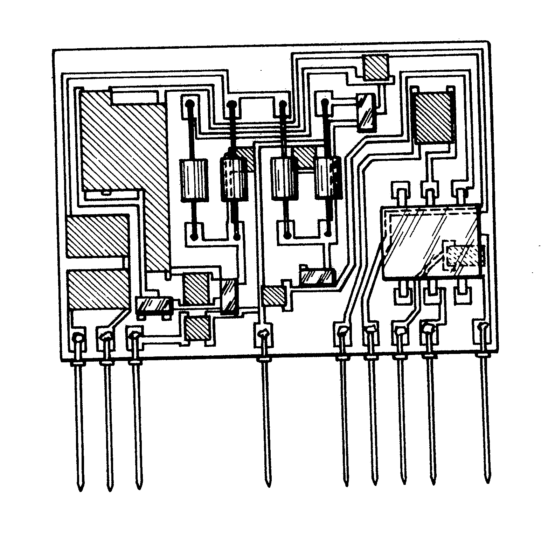

Un exemple de circuit hybride est représenté à la figure unique, ce-annexée, réalisé par la Demanderesse selon les enseignements de la présente demande — ce circuit est un temporisateur de feux tricolores, associant sur un substrat de tôle émaillée, des couches épaisses — par exemple des couches conductrices obtenues à partir d'une encre au cuivre — ainsi que des composants actifs divers simples (diodes, transistors ...) ou complexes (circuit photocoupleur, référencé CNY 57 de chez RTC).

De tels supports pour circuits hybrides peuvent être constitués d'une tôle émaillée, par exemple du type émail masse, utilisée notamment par la firme ALPHAMETALS, ou encore du type émail blanc, opacifié à l'oxyde de titane, utilisée notamment par les constructeurs d'appareils ménagers, par exemple la firme C. E. M. A., mais qui conviennent également en tant que support, pour le dépôt d'encres sérigraphiables.

Ces émaux blancs sont déposés sur une tôle d'acier décarburé, recouvert préalablement d'une fine couche de nickel (1 gr/m²) après un léger décapage de la tôle, par exemple à l'aide d'acide sulfurique, de l'ordre de 20—30 gr/m². Un exemple d'émail blanc opacifé au titane est ici donné à titre d'exemple non limitatif:

| | |
|---|---|
| oxyde de zinc | 1,70 |
| acide borique | 4,70 |
| borax déshydraté | 19,00 |
| fluosilicate de soude | 6,00 |
| quartz | 33,80 |
| carbonate de potasse | 6,20 |
| nitrate de potasse | 5,60 |
| phosphate mono-ammoniaque | 4,30 |
| oxyde de titane | 18,70 |
| | 100,00 |

Le développement des capteurs pour les produits blancs électroménagers (machine à laver, frigidaire ...) a conduit la Demanderesse à effectuer des dépôts d'encres sérigraphiables, conformes à la présente invention, sur ces supports émaillés et les résultats obtenus se sont avérés excellents, tant pour la tenue mécanique (résistance à la traction, soudabilité ...) que pour les qualités électriques des couches ainsi réalisées.

## Revendications

1. Mélange de départ, destiné à obtenir par addition d'un véhicule organique, une encre sérigraphiable, à déposer en couche épaisse et à cuire sous atmosphère non oxydante et comprenant au moins, sous forme pulvérulente, une partie vitreuse dite passive et une partie dite active, caractérisé en ce qu'il comprend également un (ou plusieurs) oxyde(s) de plomb, à un degré d'oxydation supérieur à 2, sous forme pulvérulente, en des proportions volumiques comprises entre 0 (non compris) et 20%.

2. Mélange de départ, selon la revendication 1, caractérisé en ce que l'on choisit comme oxyde, le bioxyde de plomb $PbO_2$, en des proportions volumiques comprises entre 5 et 15%.

3. Mélange de départ, selon la revendication 1 ou 2, destiné à obtenir une encre sérigraphiable isolante, caractérisé en ce que la partie vitreuse dite passive est une fritte de verre au plomb, à bas point de fusion, obtenue par fusion et broyage des oxydes suivants, avec leurs proportions molaires respectives: PbO (40—60%), $SiO_2$ (25—45%), $Al_2O_3$ (5—15%) et $B_2O_3$ (0—10%).

4. Mélange de départ, selon la revendication 3, destiné à obtenir une encre sérigraphiable isolante, caractérisé en ce que la partie vitreuse, dite passive, est une fritte du verre suivant: PbO (57%), $SiO_2$ (33%) et $Al_2O_3$ (10%).

5. Mélange de départ, selon l'une des revendications 1 à 4, destiné à obtenir une encre sérigraphiable isolante, caractérisé en ce que la partie dite active est une céramique à base d'aluminate de lanthane ($LaAlO_3$), en des proportions volumiques respectives comprises entre 1 et 10%.

6. Encre sérigraphiable, à déposer en couche(s) épaisse(s) sur un support et à cuire à basse température (inférieur à 600°C), en atmosphère non oxydante, en vue d'obtenir une couche sérigraphiée, caractérisée en ce qu'elle est obtenue par dispersion dans un véhicule organique commun, d'un mélange de départ selon l'une des revendications 1 à 5.

7. Utilisation d'une encre sérigraphiable, selon la revendication 6, caractérisée en ce qu'elle est déposée, au travers d'un écran, sur un support constitué d'une tôle émaillée, et en ce qu'elle est cuite, en atmosphère non oxydante à une température comprise entre 500 et 550°C.

8. Circuit hybride, comprenant des éléments électroniques actifs, et un réseau de couches sérigraphiées, du type simple ou multicouches utilisées pour leur propriétés conductrices ou isolantes, caractérisé en ce qu'il est obtenu par dépôt d'une encre sérigraphiable, selon la revendication 6, sur un support constitué d'une tôle émaillée et cuisson en atmosphère non oxydante à une température comprise entre 500 et 550°C, pendant environ dix minutes, puis après refroidissement, montage des éléments électroniques actifs.

9. Circuit hybride selon la revendication 8, caractérisé en ce que le support est constitué d'une tôle émaillée, du type émail masse.

10. Circuit hybride selon la revendication 8, caractérisé en ce que le support est constitué d'une tôle émaillée, du type émail blanc, opacifié à l'oxyde de titane.

## Patentansprüche

1. Ausgangsgemisch zur Herstellung einer Siebdrucktinte, durch Hinzufügung eines organischen Trägers die in einer dicken Schicht angebracht und in einer nicht oxidierenden Atmosphäre gebrannt werden muß und die mindestens einen sogenannten passiven Anteil in Form pulverförmigen Glases sowie einen sogenannten aktiven Anteil enthält, dadurch gekennzeichnet, daß das Ausgangsgemisch ebenfalls ein (oder mehrere) Bleioxid(e) in Pulverform enthält mit einem Oxidationsgrad, der größer ist als 2, bei Volumenverhältnissen, die zwischen 0 (nicht inbegriffen) und 20% liegen.

2. Ausgangsgemisch nach Anspruch 1, dadurch gekennzeichnet, daß als Oxid Bleidioxid $PbO_2$ gewählt ist in Volumenverhältnissen, die zwischen 5 und 15% liegen.

3. Ausgangsgemisch nach Anspruch 1 oder 2 für eine isolierende Siebdrucktinte, dadurch gekennzeichnet, daß der sogenannte passive Anteil in Form von Glas eine Bleiglasfritte mit einem niedrigen Schmelzpunkt ist, die durch Schmelzen und Zermahlen der nachfolgenden Oxide mit ihren spezifischen Molverhältnissen erhalten ist: PbO (40—60%), $SiO_2$ (25—45%), $Al_2O_3$ (5—15%) und $B_2O_3$ (0—10%).

4. Ausgangsgemisch nach Anspruch 3 für eine isolierende Siebdrucktinte, dadurch gekennzeichnet, daß der sogenannte passive Anteil in Form von Glas eine Glasfritte entsprechend: PbO (57%), $SiO_2$ (33%) und $Al_2O_3$ (10%) ist.

5. Ausgangsgemisch nach einem der Ansprüche 1 bis 4 für eine isolierende Siebdrucktinte, dadurch gekennzeichnet, daß der sogenannte aktive Anteil eine Keramik auf Basis eines Lanthanaluminats ($LaAlO_3$) ist in Volumenverhältnissen, die zwischen 1 und 10% liegen.

6. Siebdrucktinte, die in einer dicken Schicht oder in dicken Schichten auf einem Träger angebracht wird und bei einer Temperatur (niedriger als 600° C) in einer nicht oxidierenden Atmosphäre zur Ausbildung einer Siebdruckschicht gebrannt wird, dadurch gekennzeichnet, daß diese durch Dispersion in einem herkömmlichen organischen Träger aus einem Ausgangsgemisch nach einem der Ansprüche 1 bis 5 erhalten ist.

7. Verwendung einer Siebdrucktinte nach Anspruch 6, dadurch gekennzeichnet, daß diese durch ein Sieb hindurch auf einen Träger aufgebracht wird, der aus emailliertem Plattenmaterial besteht und daß diese Tinte in nicht oxidierender Atmosphäre bei einer Temperatur zwischen 500 und 550° C gebrannt wird.

8. Hybridschaltung mit aktiven elektronischen Bauelementen und einem Netzwerk aus Siebdruckschichten vom einfachen oder vom Mehrschichttyp, die wegen ihrer leitenden oder isolierenden Eigenschaften benutzt werden, dadurch gekennzeichnet, daß diese durch Aufbringen einer Siebdrucktinte nach Anspruch 6 auf einen Träger aus emailliertem Plattenmaterial und durch Brennen in nicht oxidierender Atmosphäre bei einer Temperatur zwischen 550 und 550° C während etwa 10 Minuten mit nachfolgender Abkühlung und Montage der aktiven elektronischen Elemente erhalten ist.

9. Hybridschaltung nach Anspruch 8, dadurch gekennzeichnet, daß der Träger aus emailliertem Blechmaterial vom Massentyp besteht.

10. Hybridschaltung nach Anspruch 8, dadurch gekennzeichnet, daß der Träger aus weißemailliertem Blechmaterial besteht, wobei das Email mit Hilfe von Titanoxid undurchsichtig gemacht worden ist.

**Claims**

1. A starting mixture for use in obtaining a silk-screening ink by the addition of an organic carrier, which ink is to be deposited in a thick layer, is to be fired in a non-oxidizing atmosphere and comprises at least, in powder form, a so-called passive glass portion and a so-called active portion, characterized in that it also comprises one (or more) lead oxide(s), in powder form, having a degree of oxidation which exceeds 2 in volume ratios which are between 0 (not included) and 20%.

2. A starting mixture as claimed in claim 1, characterized in that lead dioxide $PbO_2$ in volume ratios between 5 and 15% is chosen as the oxide.

3. A starting mixture as claimed in claim 1 or 2, for use in obtaining an insulating silk-screening ink, characterized in that the so-called passive glass portion is a low-melting-point lead glass frit which is obtained by melting and grinding the following oxides with their respective molar proportions: PbO (40—60%), $SiO_2$ (25—45%), $Al_2O_3$ (5—15%) and $B_2O_3$ (0—10%).

4. A starting mixture as claimed in claim 3, for use in obtaining an insulating silk-screening ink, characterized in that the so-called passive glass portion is a frit of the following glass: PbO (57%), SiO (33%) and $Al_2O_3$ (10%).

5. A starting mixture as claimed in any of the claims 1 to 4, for use in obtaining an insulating silk-screening ink, characterized in that the so-called active portion is a ceramic on the basis of a lanthanum aluminate ($LaAlO_3$) in the respective volume proportions which are between 1 and 10%.

6. A silk-screening ink which is to be deposited on a carrier in a thick layer or in thick layers and is to be fired at a low temperature (lower than 600° C) in a non-oxidizing atmosphere, to obtain a silk-screened layer, characterized in that it is obtained by dispersion of a starting mixture as claimed in any of the claims 1 to 5 in a common organic carrier.

7. The use of a silk-screening ink as claimed in claim 6, characterized in that it is deposited on a support through a screen, the support consisting of enamelled sheet material, and that it is fired in a non-oxidizing atmosphere at a temperature between 500 and 550° C.

8. A hybrid circuit of the single or multilayer type comprising active electronic elements and a network of silk-screened layers, which are used for their conductive or insulating properties, characterized in that it is obtained by deposition of a silk-screening ink according to claim 6 on a support which consists of enamelled sheet material and firing in a non-oxidizing atmosphere at a temperature between 500 and 550° C for approximately 10 minutes, then after cooling, assembling the active electronic elements.

9. A hybrid circuit as claimed in claim 8, characterized in that the support consists of enamelled sheet material of the type mass enamel.

10. A hybrid circuit as claimed in claim 8, characterized in that the support consists of enamelled sheet material of the white enamel type which has been made opaque by means of titanium oxide.